# FASCICULE DE BREVET EUROPEEN

(11) **EP 0 712 210 B1**
(45) Date de publication et mention de la délivrance du brevet: **12.07.2000**
(21) Numéro de dépôt: 95410126.7
(22) Date de dépôt: 08.11.1995
(51) Int. Cl.: H03L 7/07, H04L 7/00

(54) **Circuit de transmission de données en mode asynchrone à fréquence libre de réception calée sur la fréquence d'émission**
Schaltung zur Übertragung von Daten in asynchronem Modus über eine mit der Sendefrequenz verriegelte freie Empfangsfrequenz
Transmission circuit for data in asynchronous mode via a free receiving frequency coupled with the sending frequency

(30) Priorité: 09.11.1994 FR 9413786
(43) Date de publication de la demande: 15.05.1996
(73) Titulaire: STMicroelectronics S.A., 94250 Gentilly (FR)
(72) Inventeur: Belot, Didier, F-38140 Rives (FR); Dugoujon, Laurent, F-38720 Saint Bernard du Touvet (FR)
(74) Mandataire: de Beaumont, Michel

(56) Documents cités:
- EP-A- 0 138 434
- EP-A- 0 480 597
- WO-A-93/14570
- US-A- 5 283 483
- US-A- 5 302 919

## Description

La présente invention concerne un circuit de transmission de données en mode asynchrone (ATM) à haut débit. Elle s'applique plus particulièrement à la reconstitution d'une horloge d'échantillonnage lors de la réception de données transmises en mode asynchrone.

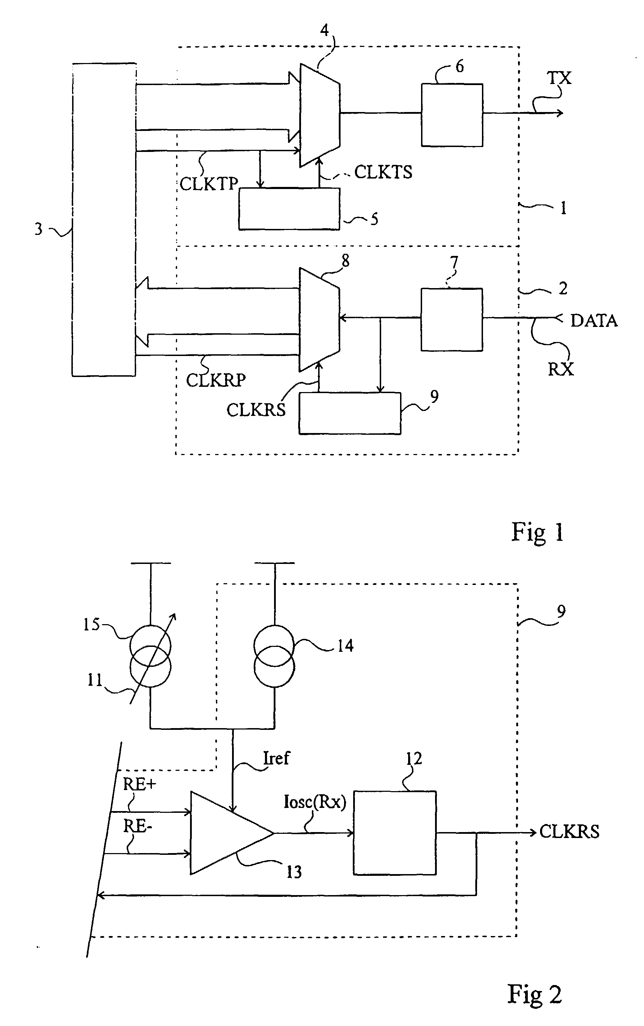

La figure 1 représente schématiquement un circuit de transmission de données en mode asynchrone. Ce circuit comprend un module d'émission 1 et un module de réception 2.

Côté émission, les données à transmettre sont constituées de données binaires envoyées en parallèle (par exemple, sur huit bits) par un dispositif de traitement des données 3 vers un multiplexeur 4 de sérialisation. Ce multiplexeur est commandé par une boucle à verrouillage de phase (PLL) 5 fournissant un signal d'horloge d'émission des données en série CLKTS qui est en phase avec la fréquence CLKTP d'émission des données en parallèle fournie par le dispositif 3. La sortie du multiplexeur 4 est reliée à un registre logique 6. Le signal en sortie du registre 6 est alors envoyé sur la ligne de transmission Tx qui est généralement constituée d'un câble coaxial ou de fibres optiques.

Dans des applications à haut débit, la fréquence d'horloge CLKTP est, par exemple, de 77,76 MHz et la fréquence de transmission CLKTS qui correspond à la fréquence fournie par un oscillateur commandé en tension (VCO) de la boucle 5 est, par exemple, de 622,08 MHz.

Côté réception, Le signal reçu Rx traverse un amplificateur de niveau 7 puis est envoyé sur un démultiplexeur 8 ainsi que sur une boucle à verrouillage de phase 9. Cette boucle 9 est chargée de retrouver la fréquence d'horloge CLKRS du signal de données DATA. En effet, une caractéristique d'une transmission de données en mode asynchrone est que la fréquence d'horloge CLKTS de codage des données n'est pas transmise. Seules les données, généralement regroupées par cellules de quarante-huit bits précédés de cinq bits d'en-tête, sont transmises.

La boucle 9 délivre au démultiplexeur 8 la fréquence d'échantillonnage des données CLKRS. Le démultiplexeur délivre au dispositif de traitement des données 3, à la fois les données en parallèle sur huit bits et leur fréquence d'horloge CLKRP.

Un problème qui se pose est lié au fait que le signal reçu est un signal pseudo-aléatoire qui est donc irrégulier. De plus, ce signal peut comporter des périodes longues pendant lesquelles les bits sont stables. En pratique, le signal reçu par la boucle à verrouillage de phase 9 du module de réception 2 peut comporter jusqu'à soixante-douze bits stables. La boucle à verrouillage de phase comporte un comparateur de phase qui délivre à un filtre passe-bas le résultat de la comparaison de phase entre le signal reçu et un signal recréé par un oscillateur commandé en tension (VCO) constitué d'un multivibrateur astable. Pour délivrer au démultiplexeur 8 la fréquence d'échantillonnage CLKRS même pendant les périodes où les bits sont stables, la boucle à verrouillage de phase est réglée sur la fréquence libre CLK0 du multivibrateur pendant ces périodes.

Le recours à la fréquence libre CLK0 du multivibrateur en tant que signal d'échantillonnage CLKRS impose de pouvoir ajuster cette fréquence libre en fonction des conditions de fonctionnement, par exemple, des variations de la température de fonctionnement.

Une première solution est représentée à la figure 2. Elle consiste à disposer d'un potentiomètre de réglage 11 actionné en l'absence de données pour ajuster la fréquence libre CLKO du multivibrateur 12. La commande du multivibrateur 12 s'effectue en courant. Ce courant est fourni par la sortie d'un amplificateur différentiel 13, monté en convertisseur tension-courant et recevant en entrée les deux tensions d'erreurs de phase issues du filtre passe-bas de la boucle 9. Le filtre délivre deux tensions d'erreurs, respectivement RE+ et RE-, dans la mesure où le circuit est en logique en mode couplé. Le courant de référence de l'amplificateur 13, c'est-à-dire le courant autour duquel va varier le courant IoscRx délivré au multivibrateur 12, est fixé par un courant IRef. Ce courant IRef représente la somme d'un courant délivré par une source de courant interne 14 et d'un courant délivré par une source de courant externe 15 ajustée par le potentiomètre 11. Dans le cas où les bits du signal DATA sont stables, la différence entre les tensions d'erreurs RE+ et RE- est nulle et le courant IoscRx est égal à IRef.

Cette solution empirique n'est pas adaptée à une fabrication en série. En effet, elle impose à l'utilisateur de régler manuellement son circuit au début de chaque transmission pour ajuster la fréquence libre du multivibrateur 12 sur la fréquence de 622,08 MHz.

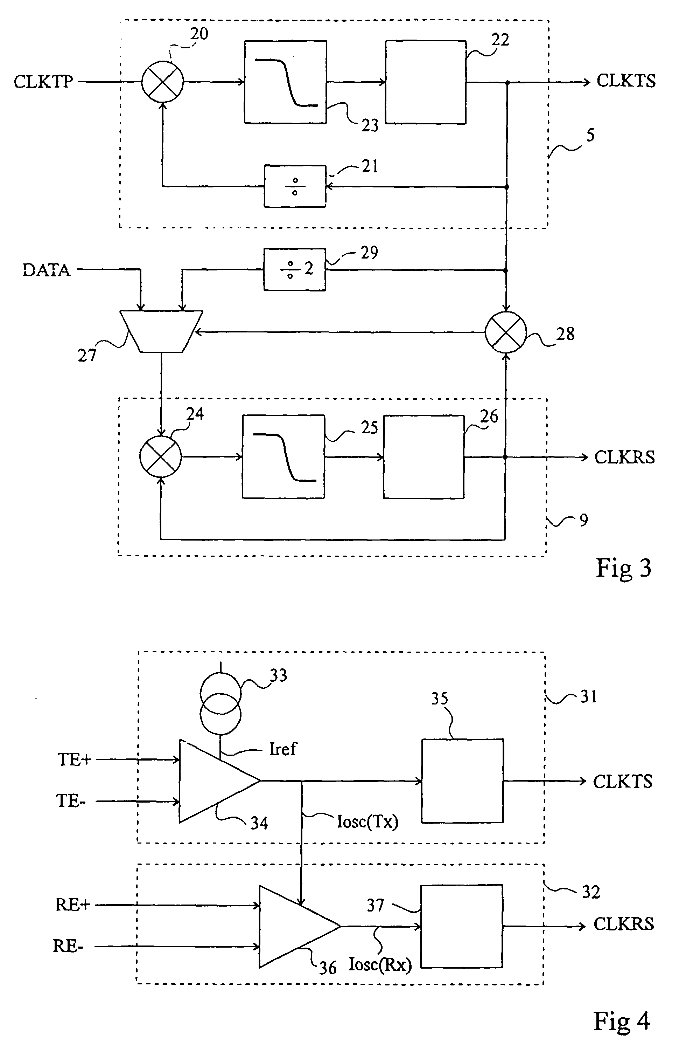

La figure 3 illustre une deuxième solution qui consiste à utiliser pendant les périodes où les données reçues sont stables, la fréquence d'horloge CLKTS disponible dans le module d'émission 1.

Côté émission, la boucle à verrouillage de phase 5 reçoit le signal CLKTP du dispositif 3. La phase de cette fréquence d'horloge est comparée au sein d'un comparateur de phase 20 par rapport à une fréquence reconstituée au moyen d'un diviseur 21 qui reçoit la fréquence d'émission CLKTS. Cette fréquence CLKTS provient de l'ajustement d'un VCO 22 constitué comme précédemment d'un multivibrateur astable commandé à partir du signal de sortie d'un filtre passe-bas 23. Bien que le VCO 22 soit comme dans le cas de la figure 2, commandé par deux tensions d'erreurs de phase délivrées par le filtre 23, une seule liaison a été représentée pour des raisons de clarté.

Côté réception, la boucle à verrouillage de phase 9 comporte de même un comparateur de phase 24 suivi d'un filtre passe-bas 25 et d'un VCO 26 également constitué d'un multivibrateur astable. Le VCO 26 délivre la fréquence d'horloge CLKRS.

Pour déterminer les périodes pendant lesquelles le module de réception doit utiliser la fréquence d'émission CLKTS, le signal de données reçues DATA est envoyé sur une première entrée d'un multiplexeur 27 à deux entrées dont la seconde entrée reçoit le signal CLKTS issu du VCO 22 et divisé par deux en fréquence au moyen d'un diviseur 29. Le recours au diviseur 29 est lié au fait qu'un bit de donnée est présent pendant une demi-période de la fréquence CLKTS. La sortie du multiplexeur 27 constitue le signal envoyé sur la première entrée du comparateur de phase 24 dont la seconde entrée reçoit le signal CLKRS de sortie du VCO 26. La sélection entre les deux entrées du multiplexeur 27 est assurée par un comparateur de fréquences 28 qui compare la fréquence du signal CLKTS par rapport à la fréquence du signal CLKRS.

Ainsi, lorsque le signal de données se trouve dans une période où les données sont stables, la fréquence CLKRS délivrée par le VCO 26 s'écarte de manière importante de la fréquence d'émission CLKTS. Le multiplexeur 27 délivre alors au comparateur de phase 24, le signal issu du diviseur 29 qui correspond au signal CLKTS divisé par deux en fréquence. Par contre, hors de ces périodes les fréquences CLKTS et CLKRS sont proches et le multiplexeur 27 délivre le signal de données DATA. La fréquence d'émission CLKTS est donc utilisée en cas de fortes variations de la fréquence CLKRS, ainsi qu'au démarrage du circuit qui correspond à une période stable (aucune donnée n'arrive sur le récepteur).

Un inconvénient d'un tel circuit est qu'en faisant appel à la fréquence d'émission CLKTS, on risque de perdre plusieurs cellules de données du signal transmis. En effet, la constante de temps des filtres passe-bas est trop importante devant la durée de transmission d'un bit de donnée. Cette constante de temps est de l'ordre de 70 ns alors qu'à la fréquence de 622 MHz, la durée d'un bit est de 3,2 ns. Si un tel circuit fonctionne correctement pour un signal à basse fréquence (de l'ordre de 500 kHz), son utilisation pour des circuits de transmission à haut débit entraîne des pertes d'informations.

Le document US-A-5 302 919 décrit un circuit destiné à l'écriture de données sur un disque dur et comportant deux oscillateurs commandés en tension. Ce circuit utilise une structure non-différentielle et est en technologie MOS. En raison de sa structure, ce circuit qui est destiné à des fréquences de l'ordre d'une dizaine de MHz ne peut être appliqué à des fréquences telles que celles utilisées dans les transmissions de données à haut débit en raison du bruit qui se superposerait alors aux signaux de commande. Ce bruit entraînerait une gigue de phase qui dépasserait les tolérances admissibles fixées par les normes de transmission de données à haut débit.

La présente invention vise à pallier les inconvénients des solutions existantes en proposant un circuit qui permette d'utiliser la fréquence d'émission des données au sein du module de réception lorsque les données reçues ne permettent pas une extraction de la fréquence de réception tout en assurant une fréquence stable en fonction des conditions de fonctionnement et en évitant les pertes d'informations.

Pour atteindre ces objets, la présente invention prévoit un circuit de transmission de données à haut débit en mode asynchrone du type comportant deux boucles à verrouillage de phase associées, respectivement, à un module d'émission et à un module de réception et pourvues, chacune, d'un oscillateur commandé en tension constitué d'un multivibrateur astable, le courant de référence fixant la fréquence libre d'oscillation du multivibrateur associé au module de réception correspondant au courant d'ajustement en fréquence du multivibrateur associé au module d'émission et chaque oscillateur commandé en tension comportant un amplificateur différentiel, monté en convertisseur tension-courant, recevant deux tensions représentant l'erreur de phase de la boucle à laquelle il est associé et délivrant un courant d'ajustement en fréquence de son multivibrateur astable, la sortie de l'amplificateur différentiel de l'oscillateur d'émission étant reliée à la borne de courant de référence de l'amplificateur différentiel de l'oscillateur de réception.

Selon un mode de réalisation de la présente invention, tous les étages différentiels du circuit sont réalisés en technologie bipolaire.

Selon un mode de réalisation de la présente invention, la fréquence libre du multivibrateur associé à l'oscillateur d'émission fixée par son courant de référence est de 622,08 MHz.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1 à 3 qui ont été décrites précédemment sont destinées à exposer l'état de la technique et le problème posé ; et
la figure 4 représente un mode de réalisation d'un circuit d'adaptation de la fréquence libre d'un oscillateur d'extraction de la fréquence sous laquelle sont reçues les données d'un circuit de transmission de données en mode asynchrone selon l'invention.

Pour des raisons de clarté les mêmes éléments ont été désignés par les mêmes références aux différentes figures. De même, alors que tous les constituants des circuits décrits sont en logique en mode couplé et sont donc à sorties complémentaires, une seule liaison a été représentée entre les différents éléments. En pratique, deux liaisons sont utilisées entre chaque élément mais elles ne sont représentées que lorsque qu'elles sont nécessaires à la compréhension de l'invention.

Le circuit selon l'invention, tel que représenté à la figure 4, est destiné à être intégré dans un circuit de transmission de données en mode asynchrone du type de celui représenté à la figure 1.

La figure 4 représente les deux oscillateurs commandés en tension 31 et 32 des boucles à verrouillage de phase 5 et 9 associées, respectivement, aux modules d'émission 1 et de réception 2.

Le VCO 31 associé au module d'émission comporte une source de courant interne 33 constituée, par exemple, d'une résistance qui fournit à un amplificateur différentiel 34, monté en convertisseur tension-courant, un courant de référence IRef. L'amplificateur 34 reçoit sur ses deux entrées les tensions d'erreurs de phase TE+ et TE- issues du filtre passe-bas de la boucle 5. La différence de potentiel indicatrice de l'erreur de phase est convertie en un courant IoscTx qui est envoyé sur la borne de commande du multivibrateur 35 qui est dimensionné pour avoir une fréquence libre d'oscillation d'environ 622,08 MHz si IoscTx est égal à IRef.

Côté réception, un amplificateur différentiel 36 du VCO 32 reçoit sur ses deux entrées les tensions d'erreurs de phase RE+ et RE- issues du filtre passe-bas de la boucle 9. La sortie de l'amplificateur 36 délivre également un courant de commande IoscRx du multivibrateur 37 du VCO 32. Mais, le courant de référence de l'amplificateur 36 est ici constitué par le courant IoscTx de sortie de l'amplificateur différentiel 34 associé au VCO 31.

Ainsi, lorsque les bits reçus par le module 2 sont stables, les deux tensions RE+ et RE- d'entrée de l'amplificateur 36 sont égales et le courant de sortie IoscRx de l'amplificateur 36 est fixé à IoscTx. Si, par contre, le signal de données est exploitable pour extraire la fréquence de réception, la différence entre les deux tensions d'erreurs RE+ et RE- de l'amplificateur 36 va faire varier le courant IoscRx autour de sa valeur de référence, ici IoscTx.

Une caractéristique de l'invention est d'utiliser le courant d'ajustement de la fréquence d'oscillation du multivibrateur associé au module d'émission en tant que courant de référence du multivibrateur associé au module de réception. Ainsi, au lieu de reporter au sein du module de réception la fréquence d'émission qui nécessite un ajustement du multivibrateur de réception au moyen de la boucle à verrouillage de phase, on ajuste directement le multivibrateur sur cette fréquence en agissant sur son courant de référence.

Les variations du courant de référence du multivibrateur 37 lié au module de réception s'effectuent ainsi autour d'une valeur qui prend déjà en compte certains paramètres de fonctionnement comme, par exemple, la température. Ainsi, la valeur centrale du courant IoscRx et donc la fréquence libre d'oscillation du multivibrateur 37 est fixée à la fréquence d'émission mais sans passer par l'emploi de filtres qui induisent un retard entraînant une perte de données. Les variations de la fréquence d'oscillation du multivibrateur 37 ne s'effectuent plus désormais autour d'une valeur fixée par une source de courant indépendante, mais autour de la fréquence d'émission. La fréquence libre de l'oscillateur de réception est donc très proche de la fréquence réelle d'émission.

L'écart entre cette fréquence libre et la fréquence d'émission dépend désormais uniquement des dispersions technologiques des composants utilisés et non plus comme précédemment des conditions de fonctionnement.

Selon l'invention, les courants IoscTx et IoscRx d'ajustement en fréquence des multivibrateurs 35 et 37 sont obtenus par une structure différentielle. Un avantage d'un recours à des amplificateurs différentiels 34 et 36 est qu'ils permettent de réduire le bruit sur les signaux de commande des multivibrateurs, respectivement 35 et 37, qui sont ainsi moins sensibles au bruit susceptible d'être présent sur les lignes d'alimentation du circuit. De plus, une structure différentielle permet de réduire le bruit apporté par les convertisseurs tension-courant sur les lignes d'alimentation. Ainsi, on réduit la gigue de phase.

Un autre avantage de la présente invention est qu'elle permet d'augmenter la plage d'ajustement de l'oscillateur commandé en tension pour une même amplitude de signal d'erreur. Par exemple, pour une amplitude de tension d'erreur différentielle de 1 volt, les potentiels TE+ (ou RE+) et TE- (ou RE-) peuvent, chacun, varier entre + 0,5 volt et - 0,5 volt. On dispose alors d'une plage d'ajustement correspondant à une tension d'erreur variant entre -1 volt (TE+ = -0,5 volt et TE- = +0,5 volt) et +1 volt (TE+ = +0,5 volt et TE- = -0,5 volt). Cela revient à doubler, virtuellement, la plage d'ajustement de l'oscillateur par rapport à un circuit où les convertisseurs tension-courant ne reçoivent pas un signal d'erreur différentiel (par exemple, un circuit tel que décrit dans le document US-A-5 302 919).

Selon l'invention, le circuit est réalisé en technologie BICMOS et tous les étages différentiels, notamment les amplificateurs 34 et 36, sont en technologie bipolaire pour assurer un fonctionnement correct aux fréquences de transmissions de l'ordre de plusieurs centaines de MHz.

Les multivibrateurs 35 et 37 sont, de préférence, réalisés sur une même puce de circuit intégré pour que leurs constituants soient homogènes. Ainsi, les seules dispersions technologiques auxquelles on doit veiller pour une mise en oeuvre optimale de l'invention sont celles liées à la taille des composants sur une même puce ce qui est parfaitement contrôlable.

La tolérance admissible dans les dispersions technologiques est liée à la dérive admissible entre les fréquences des multivibrateurs. Pour éliminer tout risque de perte de données on veillera à ce que la dérive sur soixante-douze bits de données soit inférieure à une demi-période de la fréquence de 622,08 MHz.

Ainsi, l'invention assure un décodage optimal des données reçues par le circuit de transmission asynchrone.

Un autre avantage de la présente invention est qu'elle ne nécessite qu'une source de courant pour les deux multivibrateurs associés, respectivement, aux modules d'émission et de réception. En effet, seule la source fournissant le courant IRef est nécessaire, le courant de référence du multivibrateur de réception étant fourni par le multivibrateur d'émission. Ainsi, la consommation d'énergie au sein du circuit de transmission asynchrone est moindre. La source de courant 33 est, par exemple, constituée d'une source de courant ajustée selon la température de fonctionnement.

Un autre avantage de la présente invention est qu'elle permet d'effectuer des tests sur la fréquence libre des oscillateurs commandés en tension sans que les mesures dépendent des tolérances d'obtention d'une grandeur de consigne particulière. En effet, il suffit d'annuler la tension d'erreur différentielle, par exemple, en reliant les deux bornes d'entrée d'un amplificateur différentiel 34 ou 36 pour obtenir la fréquence libre d'oscillation du multivibrateur, respectivement 35 ou 37, de manière rigoureusement exacte. Cela n'est pas le cas d'un circuit tel que décrit dans le document US-A-5 302 919 car la mesure dépendrait de la précision avec laquelle pourrait être obtenue une tension de consigne appliquée en entrée du convertisseur tension-courant. L'invention permet donc d'effectuer, par exemple, une caractérisation du circuit contenant les oscillateurs commandés en tension qui soit exacte et indépendante de toute consigne.

Bien entendu, la présente invention est susceptible de diverses variantes et modifications qui apparaîtront à l'homme de l'art. En particulier, chacun des composants décrits pourra être remplacé par un ou plusieurs éléments remplissant la même fonction. En outre, la réalisation pratique des multivibrateurs astables dans le respect des contraintes et des indications fonctionnelles données dans le présent mémoire est à la portée de l'homme du métier.

## Revendications

1. Circuit de transmission de données à haut débit en mode asynchrone du type comportant deux boucles à verrouillage de phase (5, 9) associées, respectivement, à un module d'émission (1) et à un module de réception (2) et pourvues, chacune, d'un oscillateur commandé en tension (31, 32) constitué d'un multivibrateur astable (35, 37), le courant de référence fixant la fréquence libre d'oscillation du multivibrateur (37) associé au module de réception (2) correspondant au courant (IoscRx) d'ajustement en fréquence du multivibrateur (35) associé au module d'émission (1), chaque oscillateur commandé en tension (31, 32) comportant un amplificateur différentiel (34, 36), monté en convertisseur tension-courant, recevant deux tensions (TE+, TE- ; RE+, RE-) représentant l'erreur de phase de la boucle (5, 9) à laquelle il est associé et délivrant un courant (IoscTx, IoscRx) d'ajustement en fréquence de son multivibrateur astable (35, 37), la sortie de l'amplificateur différentiel (34) de l'oscillateur (31) d'émission étant reliée à la borne de courant de référence de l'amplificateur différentiel (36) de l'oscillateur (32) de réception.

2. Circuit de transmission de données à haut débit en mode asynchrone selon la revendication 1, caractérisé en ce que tous ses étages différentiels sont réalisés en technologie bipolaire.

3. Circuit de transmission de données à haut débit en mode asynchrone selon la revendication 1 ou 2, caractérisé en ce que la fréquence libre du multivibrateur associé à l'oscillateur d'émission fixée par son courant de référence (IRef) est de 622,08 MHz.

## Patentansprüche

1. Schaltung zur Übertragung von Daten mit hoher Datenrate in asynchronem Modus vom Typ, der zwei Phasenverriegelungs- Regelschleifen (5, 9), die einem Sendemodul (1) bzw. einem Empfangsmodul (2) zugeordnet sind und die jeweils mit einem spannungsgesteuerten Oszillator (31, 32) versehen sind, der aus einem astabilen Multivibrator (35, 37) gebildet ist, wobei der Referenzstrom, der die freie Oszillationsfrequenz des dem Empfangsmodul (2) zugeordneten Mulitvibrators (37) festsetzt, dem Frequenzeinstellungsstrom (IoscRx) des dem Sendemodul (1) zugeordneten Multivibrators (35) entspricht, wobei jeder spannungsgesteuerte Oszillator (31, 32) einen Differentialverstärker (34, 36) aufweist, der als Spannungs-Strom-Umsetzer geschaltet ist, der zwei Spannungen (TE+, TE- ; RE+, RE-) empfängt, die den Phasenfehler der Schleife (5, 9) repräsentieren, der er zugeordnet ist, und einen Strom (IoscTx, IoscRx) zur Frequenzeinstellung seines astabilen Multivibrators (35, 37) abgibt, wobei der Ausgang des Differentialverstärkers (34) des Sendeoszillators (31) mit dem Referenzstromanschluss des Differentialverstärkers (36) des Empfangsoszillators (32) verbunden ist.

2. Schaltung zur Übertragung von Daten mit hoher Datenrate in asynchronem Modus nach Anspruch 1,
dadurch gekennzeichnet, dass alle ihre Differentialstufen in Bipolartechnik ausgeführt sind.

3. Schaltung zur Übertragung von Daten mit hoher Datenrate in asynchronem Modus nach Anspruch 1 oder 2,
dadurch gekennzeichnet, dass die freie Frequenz des dem Sendeoszillator zugeordneten Mulitvibrators, die durch den Referenzstrom (IRef) festgesetzt ist, 622,08 MHz beträgt.

## Claims

1. A circuit for transmitting data in an asynchronous transfer mode comprising two phase-locked loops (PLL's) (5, 9) associated with a transmission unit (1) and a reception unit (2), respectively, each PLL being provided with a voltage-controlled oscillator (VCO) (31, 32) formed by an astable multivibrator (35, 37), a reference current fixing the free running frequency of the multivibrator (37) that is associated with the reception unit (2) corresponding to a frequency adjustment current (IoscRx) of the multivibrator (35) that is associated with the transmission unit (1), each VCO (31, 32) comprising a differential amplifier (34, 36), connected as a voltage-to-current converter, receiving two voltages (TE+, TE-, RE+, RE-) corresponding to the phase error of the PLL (5, 9) with which it is associated, and providing a frequency adjustment current (IoscTx, IoscRx) of its astable multivibrator (35, 37), the output of the differential amplifier (34) of the transmission oscillator (31) being connected to a reference current terminal of the differential amplifier (36) of the reception oscillator (32).

2. The transmission circuit of claim 1, characterized in that all differential stages are achieved in bipolar technology.

3. The transmission circuit of claim 1 or 2, characterized in that the free running frequency of the multivibrator associated with the transmission oscillator is fixed its said reference current (IRef) to 622.08 MHz.
